# EUROPEAN PATENT APPLICATION

(11) **EP 4 411 390 A1**
(43) Date of publication of application: **07.08.2024**
(21) Application number: 22920643.8
(22) Date of filing: 26.12.2022
(51) Int. Cl.: G01R 15/20

(54) **ELECTRIC CURRENT SENSOR DEVICE**

(30) Priority: 14.01.2022 JP 2022004556
(71) Applicant: AISIN CORPORATION, Kariya-shi, Aichi 448-8650 (JP)
(72) Inventor: TSUDA, Mamoru, Kariya-shi, Aichi 448-8650 (JP); MITSUBAYASHI, Noriaki, Kariya-shi, Aichi 448-8650 (JP); OMOTE, Kotaro, Kariya-shi, Aichi 448-8650 (JP)
(74) Representative: Kramer Barske Schmidtchen Patentanwälte PartG mbB
(86) International application number: PCT/JP2022/048041
(87) International publication number: WO 2023/136126

(57) **Abstract**

An electric current sensor device (7) includes a conductor (11), a detector (21) detecting magnetism generated by a current flowing through the conductor (11), a board (14) on which the detector (21) is mounted, and a heat dissipation member (16) coupled to the conductor (11) in a thermally conductive manner, the heat dissipation member dissipating heat of the conductor (11). The heat dissipation member (16) is disposed on a side opposite to the board (14) with respect to the conductor (11) in a stacking direction (Dz), and is coupled to the board (14) in a thermally conductive manner.

## Description

### TECHNICAL FIELD

The present technology relates to an electric current sensor device that measures a current flowing through a conductor.

### BACKGROUND ART

Conventionally, in a printed circuit board on which electronic components are mounted, a configuration for dissipating heat generated in the printed circuit board has been developed. For example, there is known a configuration in which a metal heat sink in contact with substantially the entire back surface is attached to a printed circuit board (see Patent Literature 1). In this configuration, the heat sink includes a fixing pin protruding to the printed circuit board side, and the fixing pin is press-fitted and fixed in a through-hole formed in the printed circuit board. The pattern land of the printed circuit board and the heat sink are finally fixed by soldering. In addition, the printed circuit board includes a heat dissipation through-hole, and heat generated by a mounted component is transferred to the heat sink through the printed circuit board to be dissipated from the heat sink.

Meanwhile, an electric current sensor device for measuring a current is provided in a device using a relatively large current, such as an inverter for a three-phase AC motor. As such an electric current sensor device, for example, a configuration is known in which a current flowing through a conductor (hereinafter, referred to as "bus bar") is measured using a magnetic detection element. The magnetic detection element is mounted on a printed circuit board as a package, for example, and the package is disposed to face the bus bar. The bus bar easily generates heat because a large current flows therethrough, and thus the package and the printed circuit board arranged to face the bus bar are heated. When the configuration in which the heat sink is attached to the printed circuit board is applied, the bus bar, the package, the printed circuit board, and the heat sink are stacked in this order, and the heat of the heated package and printed circuit board is dissipated from the heat sink to the opposite side of the bus bar.

### CITATION LIST

### PATENT LITERATURE

Patent Literature 1: JP 2009-200234 A

### SUMMARY OF INVENTION

### TECHNICAL PROBLEMS

However, in the configuration described in Patent Literature 1, internal heat generated by the use of the mounted component is dissipated, but heat generated by the bus bar, which is larger than the internal heat, cannot be efficiently dissipated. As a result, the mounted component and the printed circuit board may be affected by the heat received from the heat generated by the bus bar. As described above, there has been a demand for a configuration capable of efficiently dissipating heat generated by the bus bar while heat dissipation of the mounted component and the printed circuit board is ensured, and reducing the influence of received heat by reducing the heating of the mounted component and the printed circuit board from the bus bar.

Therefore, the present invention provides an electric current sensor device capable of reducing an influence of heat received from heat generated by a conductor on a board.

### SOLUTIONS TO PROBLEMS

The electric current sensor device includes a conductor, a detector detecting magnetism generated by a current flowing through the conductor, a board on which the detector is mounted, and a heat dissipation member coupled to the conductor in a thermally conductive manner, the heat dissipation member dissipating heat of the conductor, and in the electric current sensor device, the heat dissipation member is disposed on a side opposite to the board with respect to the conductor in a stacking direction, and is coupled to the board in a thermally conductive manner.

As a result, it is possible to reduce the influence of heat received from heat generated by the conductor on the board.

### BRIEF DESCRIPTION OF DRAWINGS

FIG. 1 is a schematic diagram illustrating a vehicle according to an embodiment.
FIG. 2 is a perspective view illustrating an electric current sensor device according to the embodiment.
FIG. 3 is an exploded perspective view illustrating the electric current sensor device according to the embodiment.
FIG. 4 is a plan view illustrating the electric current sensor device according to the embodiment.
FIG. 5 is a plan view of a main part illustrating the electric current sensor device according to the embodiment.
FIG. 6 is a cross-sectional view taken along line A-A in FIG. 4.
FIG. 7 is a wiring diagram illustrating a package according to the embodiment.
FIG. 8 is a cross-sectional view illustrating a state where the electric current sensor device according to the embodiment is attached to a case of an inverter device.
FIG. 9 is a perspective view illustrating the electric current sensor device according to the embodiment as viewed from the back side.
FIG. 10 is a graph illustrating a relationship between a bus bar pitch and magnetic interference in the electric current sensor device according to the embodiment.

### DESCRIPTION OF EMBODIMENTS

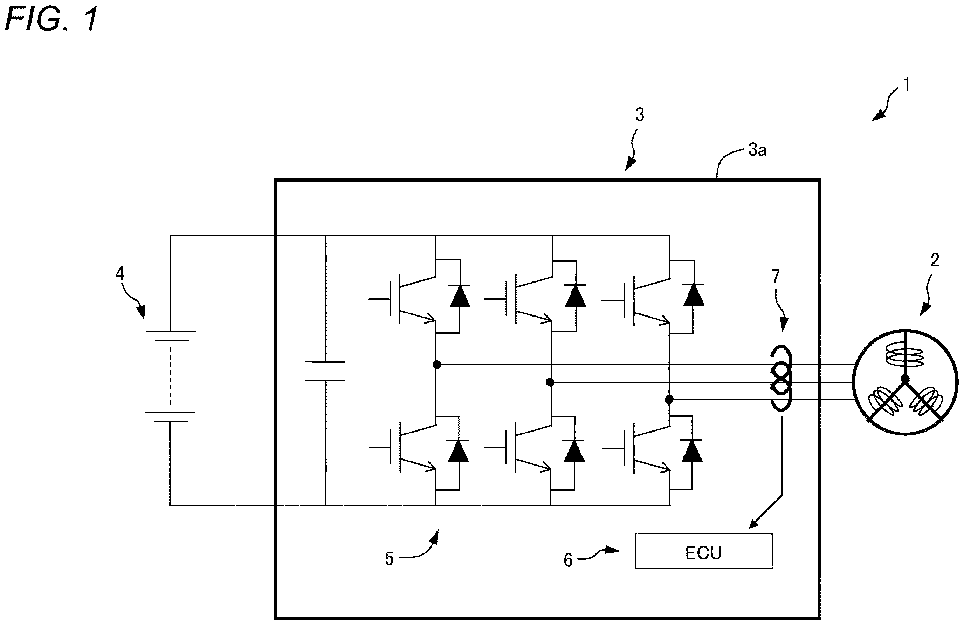

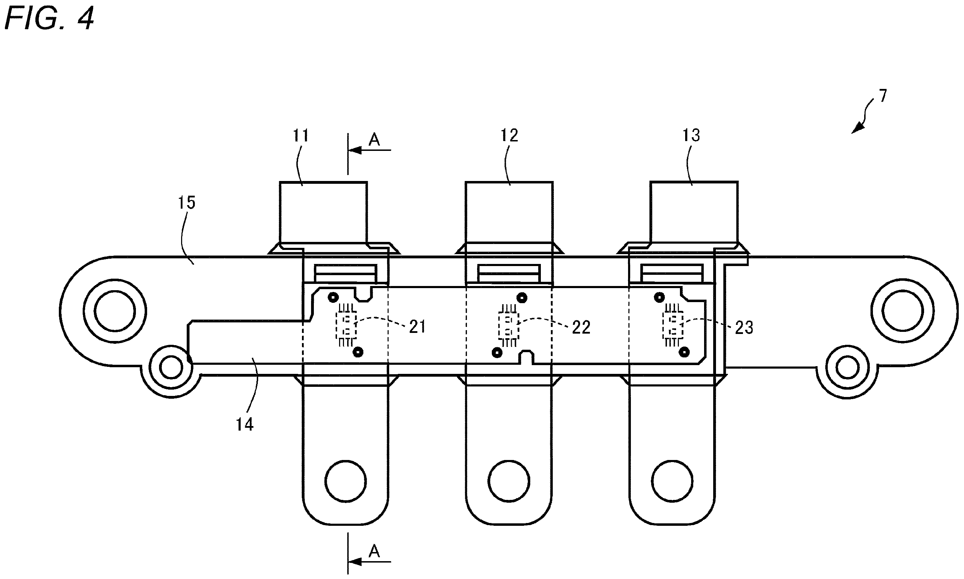

Hereinafter, an embodiment of an electric current sensor device according to the present disclosure will be described with reference to FIGS. 1 to 10. In the present embodiment, a case where the electric current sensor device is mounted on an inverter device 3 for controlling a three-phase AC motor 2 for driving a vehicle will be described.

First, the outline of a vehicle 1 will be described with reference to FIG. 1.

The vehicle 1 is a vehicle that can travel using the three-phase AC motor 2 as a drive source, such as an electric car or a hybrid car. The vehicle 1 includes the three-phase AC motor 2, the inverter device 3 for controlling the three-phase AC motor 2, and a power supply 4. The three-phase AC motor 2 is a three-phase induction motor, and has three phases of a U phase (first phase), a V phase (second phase), and a W phase (third phase) in the present embodiment. Note that the three-phase AC motor 2 is an example of a rotary electric machine that operates with a three-phase alternating current, and a known motor can be applied, and thus detailed description of the configuration and the like is omitted.

The inverter device 3 includes an inverter circuit 5, an ECU 6, and an electric current sensor device 7. The inverter circuit 5 is housed in the inverter device 3, includes a switching element corresponding to each phase of the three-phase AC motor 2, and controls an output to each phase by controlling the ECU 6 to operate the three-phase AC motor 2. Note that a known inverter circuit and a known ECU can be applied as the inverter circuit 5 and the ECU 6, and thus detailed description of the configuration and the like is omitted.

The electric current sensor device 7 is connected between the inverter circuit 5 and the three-phase AC motor 2. In the present embodiment, the electric current sensor device 7 is attached to an aluminum die-cast case 3a of the inverter device 3.

### [Electric Current Sensor Device]

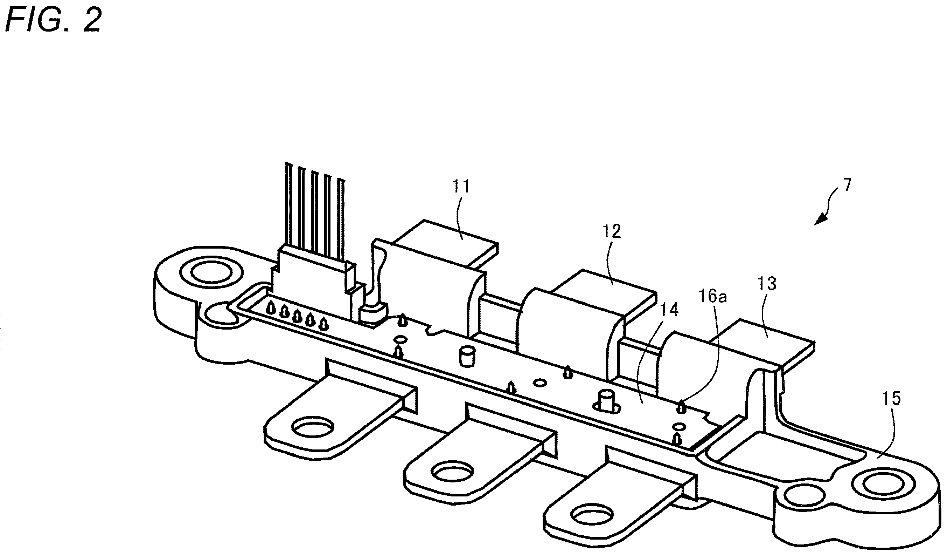

Hereinafter, the electric current sensor device 7 will be described with reference to FIGS. 2 to 10. First, the overall configuration of the electric current sensor device 7 will be described with reference to FIGS. 2 to 4. As illustrated in FIGS. 2 to 4, the electric current sensor device 7 includes three bus bars 11, 12, and 13 individually connected to three phases, a board 14, a housing 15 made of resin, and a heat sink 16 made of metal.

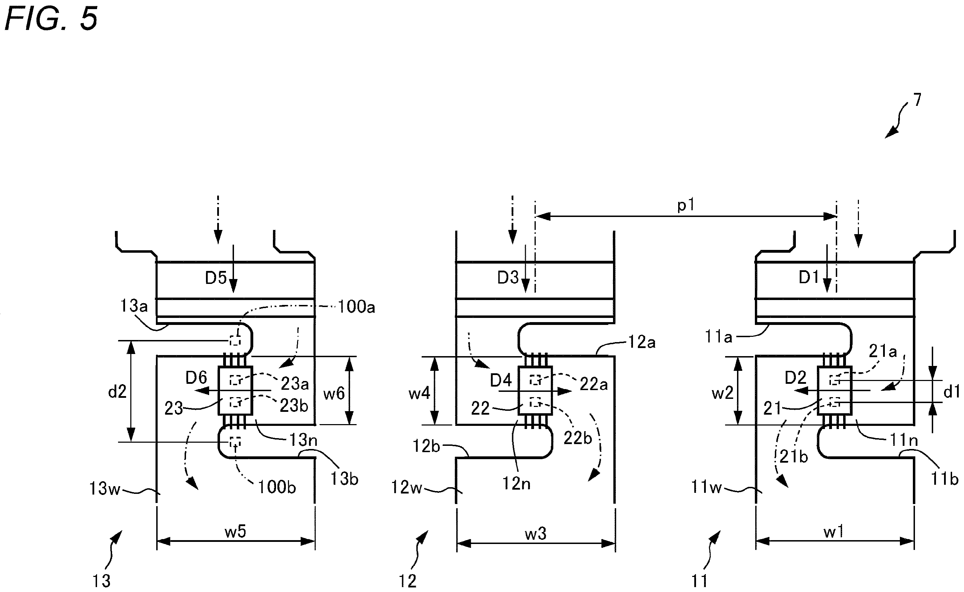

The bus bars 11, 12, and 13 are examples of conductors, and are made of copper, for example. The bus bar 11 is connected to a U-phase coil of the three-phase AC motor 2, the bus bar 12 is connected to a V-phase coil, the bus bar 13 is connected to a W-phase coil, and each of the bus bars is connected to the inverter circuit 5 (see FIG. 1). The bus bars 11, 12, and 13 are arranged at predetermined intervals. In the present embodiment, a first width w1 (see FIG. 5), which is the width of the bus bars 11, 12, and 13, is 10 mm, and a pitch p1 (see FIG. 5) between the bus bars 11, 12, and 13 is 14 mm. However, the first width w1 of and the pitch p1 between the bus bars 11, 12, and 13 are not limited thereto, and may be other values, or the pitch between the bus bars 11 and 12 and the pitch between the bus bars 12 and 13 may be different from each other.

The board 14 is a printed circuit board on which electronic components are mounted, and in the present embodiment, magnetic detection packages 21, 22, and 23 are mounted thereon. The bus bars 11, 12, and 13, the packages 21, 22, and 23, and the board 14 are stacked in a stacking direction Dz. The heat sink 16 is an example of a heat dissipation member, and is disposed on the side opposite to the board 14 with respect to the bus bars 11, 12, and 13 in the stacking direction Dz. Details of the heat sink 16 will be described later.

### [Package]

Next, the packages 21, 22, and 23 will be described in detail with reference to FIGS. 5 to 7. Each of the packages 21, 22, and 23 is a sensor that incorporates two magnetic detection elements therein and measures a magnetic flux. The package 21 is disposed facing the bus bar 11 so as to measure a magnetic flux generated when the bus bar 11 is energized, the package 22 is disposed facing the bus bar 12 so as to measure a magnetic flux generated when the bus bar 12 is energized, and the package 23 is disposed facing the bus bar 13 so as to measure a magnetic flux generated when the bus bar 13 is energized. In FIG. 5, dashed-dotted line arrows in the bus bars 11, 12, and 13 indicate current flow directions. Note that, in the present embodiment, the packages 21, 22, and 23 are similar in configuration to each other except that the measurement target is different, and thus the package 21 will be described below as a representative, and the description of the packages 22 and 23 will be omitted. Similarly, the configurations of portions of the bus bars 11, 12, and 13 facing the packages 21, 22, and 23 are similar, and thus the bus bar 11 will be described below as a representative, and the description of the bus bars 12 and 13 will be omitted.

As illustrated in FIG. 5, the bus bar 11 includes slits 11a and 11b each of which has a shape cut out from a side edge on one side or a side edge on the other side to the center side in a longitudinal direction. The slits 11a and 11b are arranged to face each other in the longitudinal direction of the bus bar 11. The bus bar 11 includes a wide portion 11w, which is an example of a first wide portion, and 11n, which is an example of a first narrow portion. In the wide portion 11w, a current flows in a first direction D1, and the width in a direction orthogonal to the first direction D1 is the first width w1. The narrow portion 11n is a region between the slits 11a and 11b, and in the narrow portion, a current flows in a second direction D2 intersecting the first direction D1, and the width in a direction orthogonal to the second direction D2 is a second width w2 narrower than the first width w1. That is, in the narrow portion 11n, the current flow direction is changed.

Similarly, the bus bar 12 includes slits 12a and 12b each of which has a shape cut out from the side edge on one side or the side edge on the other side to the center side in the longitudinal direction. The slits 12a and 12b are arranged to face each other in the longitudinal direction of the bus bar 12. The bus bar 12 includes a wide portion 12w, which is an example of a second wide portion, and 12n, which is an example of a second narrow portion. In the wide portion 12w, a current flows in a third direction D3, and the width in a direction orthogonal to the third direction D3 is a third width w3. The narrow portion 12n is a region between the slits 12a and 12b, and in the narrow portion, a current flows in a fourth direction D4 intersecting the third direction D3, and the width in a direction orthogonal to the fourth direction D4 is a fourth width w4 narrower than the third width w3.

In addition, the bus bar 13 includes slits 13a and 13b each of which has a shape cut out from the side edge on one side or the side edge on the other side to the center side in the longitudinal direction. The slits 13a and 13b are arranged to face each other in the longitudinal direction of the bus bar 13. The bus bar 13 includes a wide portion 13w, which is an example of a third wide portion, and 13n, which is an example of a third narrow portion. In the wide portion 13w, a current flows in a fifth direction D5, and the width in a direction orthogonal to the fifth direction D5 is a fifth width w5. The narrow portion 13n is a region between the slits 13a and 13b, and in the narrow portion, a current flows in a sixth direction D6 intersecting the fifth direction D5, and the width in a direction orthogonal to the sixth direction D6 is a sixth width w6 narrower than the fifth width w5.

Note that, in the present embodiment, the direction in which the slit is cut out is the same in the bus bars 11 and 13, and the direction in the bus bars 11 and 13 is opposite to the direction in the bus bar 12, but it is not limited thereto, and the directions may be the same in the bus bars 11, 12, and 13.

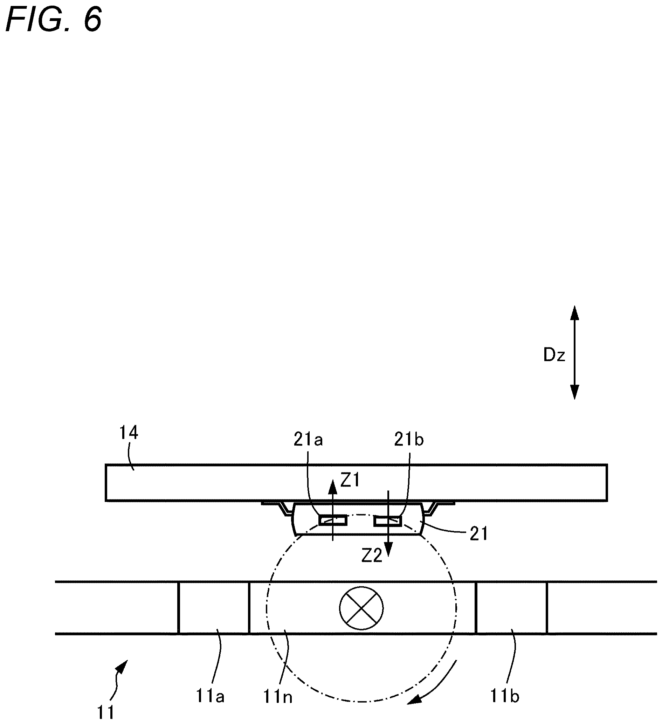

The package 21 is an example of a first detector, and includes two magnetic detection elements that detect magnetism generated by a current flowing through the bus bar 11, that is, a first Hall element 21a, which is an example of a first magnetic detection element, and a second Hall element 21b, which is an example of a second magnetic detection element. The package 21 detects the current of the bus bar 11 on the basis of the detection results of the first Hall element 21a and the second Hall element 21b. The first Hall element 21a and the second Hall element 21b are arranged side by side in a manner to be stacked on the narrow portion 11n of the bus bar 11 and to be adjacent to each other. That is, the first Hall element 21a and the second Hall element 21b are arranged in the first stacking direction Dz (see FIG. 6) of the surface of the narrow portion 11n of the bus bar 11, and are arranged side by side in a direction along the surface of the narrow portion 11n.

Similarly, the package 22 is an example of a second detector, and includes two magnetic detection elements that detect magnetism generated by a current flowing through the bus bar 12, that is, a third Hall element 22a, which is an example of the first magnetic detection element, and a fourth Hall element 22b, which is an example of the second magnetic detection element. The package 22 detects the current of the bus bar 12 on the basis of the detection results of the third Hall element 22a and the fourth Hall element 22b. The third Hall element 22a and the fourth Hall element 22b are arranged side by side in a manner to be stacked on the narrow portion 12n of the bus bar 12 and to be adjacent to each other. That is, the third Hall element 22a and the third Hall element 22b are arranged in a second stacking direction Dz (see FIG. 6) of the surface of the narrow portion 12n of the bus bar 12, and are arranged side by side in a direction along the surface of the narrow portion 12n.

The package 23 is an example of a third detector, and includes two magnetic detection elements that detect magnetism generated by a current flowing through the bus bar 13, that is, a fifth Hall element 23a, which is an example of the first magnetic detection element, and a sixth Hall element 23b, which is an example of the second magnetic detection element. The package 23 detects the current of the bus bar 13 on the basis of the detection results of the fifth Hall element 23a and the sixth Hall element 23b. The fifth Hall element 23a and the sixth Hall element 23b are arranged side by side in a manner to be stacked on the narrow portion 13n of the bus bar 13 and to be adjacent to each other. That is, the fifth Hall element 23a and the sixth Hall element 23b are arranged in a third stacking direction Dz (see FIG. 6) of the surface of the narrow portion 13n of the bus bar 13, and are arranged side by side in a direction along the surface of the narrow portion 13n.

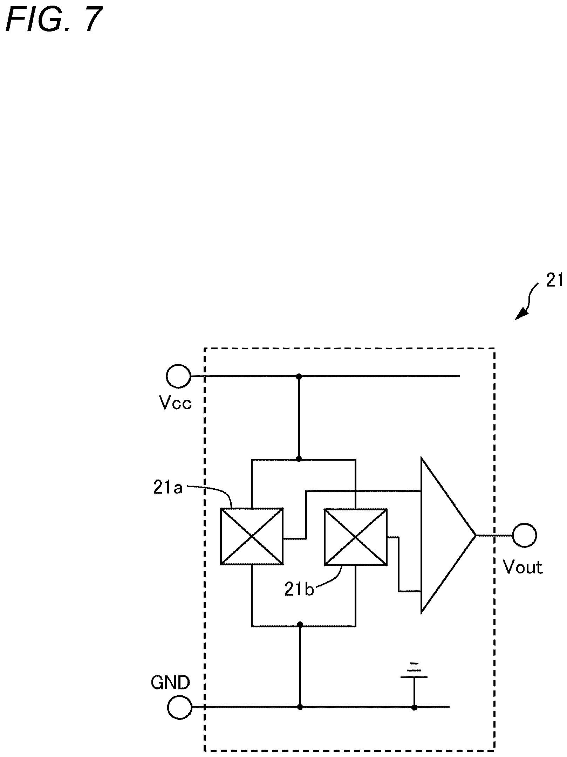

Here, the principle of measuring the magnetic flux of the bus bar 11 by the package 21 will be described with reference to FIG. 6. As illustrated in FIG. 6, it is assumed that a current flows through the narrow portion 11n of the bus bar 11 to the other side of the paper surface. At this time, a clockwise magnetic flux is generated around the narrow portion 11n with the current flow direction as the center. The package 21 is disposed to face the magnetic flux, and the first Hall element 21a can capture a magnetic flux in a direction Z1 away from the bus bar 11, and the second Hall element 21b can capture a magnetic flux in a direction Z2 approaching the bus bar 11. As illustrated in FIG. 7, the package 21 can generate a differential output between positive and negative voltages obtained by the first Hall element 21a and the second Hall element 21b, and the ECU 6 (see FIG. 1) can obtain a current value of the bus bar 11 on the basis of a signal output from the package 21.

Next, the relationship between a pitch d1 between the first Hall element 21a and the second Hall element 21b and the second width w2 of the narrow portion 11n will be described with reference to FIG. 5. If the second width w2 is less than twice the pitch d1, the narrow portion 11n is too thin, which may cause local overheating. If the second width w2 exceeds three times the pitch d1, the size of the electric current sensor device 7 increases. Therefore, the second width w2 is preferably twice or more and three times or less the pitch d1. In the present embodiment, the pitch d1 between the first Hall element 21a and the second Hall element 21b is, for example, 2.5 mm. The second width w2 of the narrow portion 11n is, for example, 6 mm. Similarly, the fourth width w4 of the narrow portion 12n and the sixth width w6 of the narrow portion 13n are preferably twice or more and three times or less the pitch d1, and in the present embodiment, the fourth width w4 and the sixth width w6 are, for example, 6 mm. Therefore, it is possible to achieve a balanced configuration without causing local overheating and without causing an increase in size of the electric current sensor device 7. In the present embodiment, as compared with the case where the first Hall element 21a and the second Hall element 21b are disposed in the slits 11a and 11b, respectively, each of the Hall elements can be less susceptible to the influence of the magnetic flux from the adjacent bus bar 12. As a result, the pitch p1 between the bus bars 11, 12, and 13 can be reduced while the current detection accuracy is maintained, and thus the electric current sensor device 7 can be downsized.

### [Heat Sink]

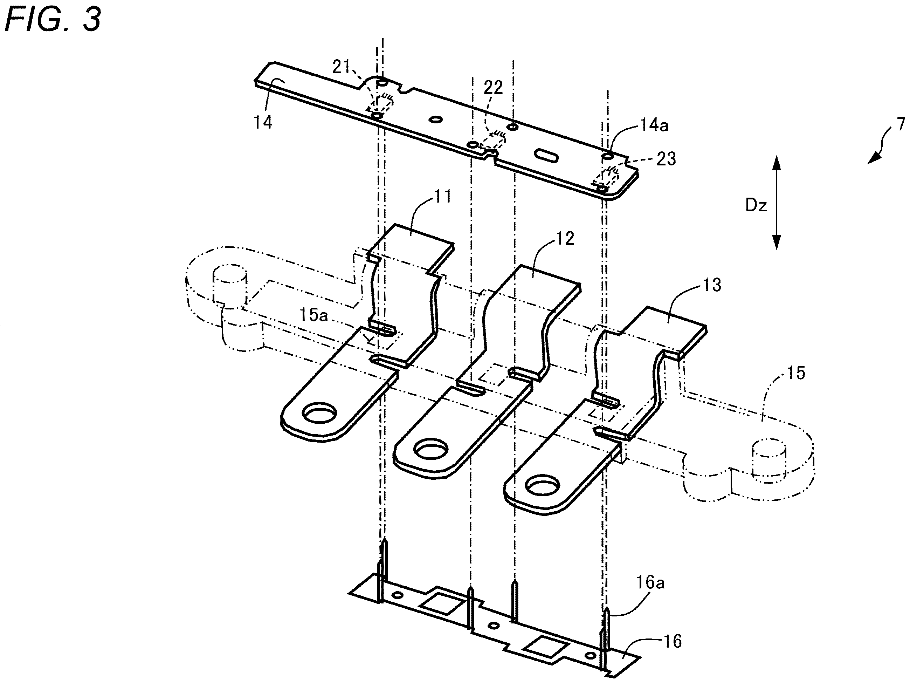

Next, the heat sink 16 will be described with reference to FIGS. 3, 8, and 9. The heat sink 16 is coupled to the bus bars 11, 12, and 13 in a thermally conductive manner, and dissipates heat of the bus bars 11, 12, and 13. The heat sink 16 is made of metal made of a non-magnetic material such as brass, and does not affect the magnetic flux generated in the bus bars 11, 12, and 13, so that the detection accuracy can be maintained high.

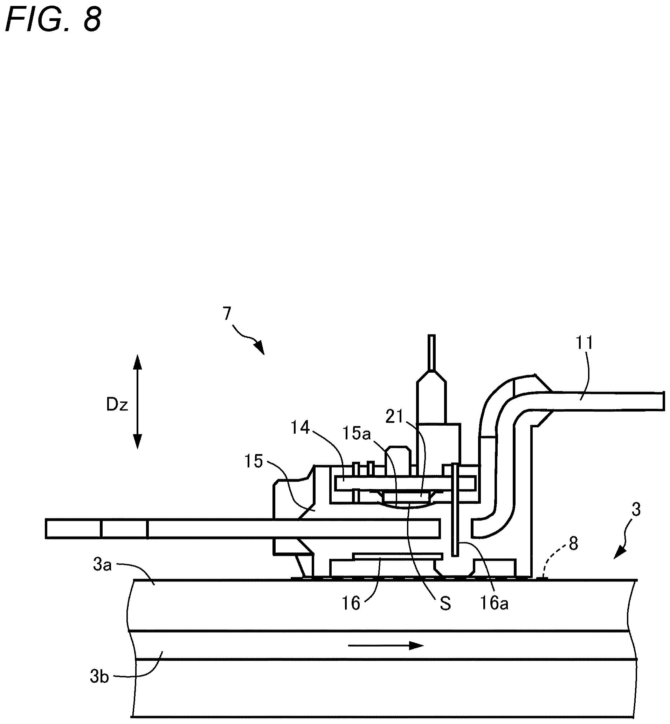

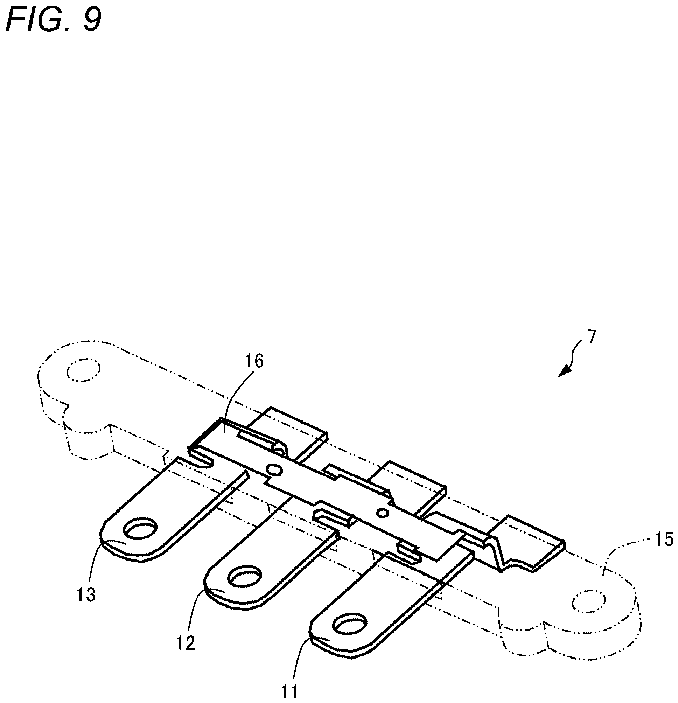

In the present embodiment, the bus bars 11, 12, and 13 and the heat sink 16 are integrally formed with the resin housing 15 by injection molding. As illustrated in FIG. 8, the bus bar 11 and the heat sink 16 are not in direct contact with each other but are in contact with each other via the housing 15. However, heat of the bus bar 11 can be released from the heat sink 16 without interposing other components therebetween. The same applies to the bus bars 12 and 13. As illustrated in FIGS. 8 and 9, the heat sink 16 is exposed on the back side of the housing 15.

The electric current sensor device 7 is attached to the case 3a of the inverter device 3 via a heat sink sheet 8 in a manner that the heat sink 16 is in contact with the case 3a via the heat sink sheet 8. The case 3a is made of, for example, aluminum die-cast, and includes a flow path 3b through which cooling water (in FIG. 8, represented by an arrow) flows inside the wall portion. Therefore, the electric current sensor device 7 is preferably attached in the vicinity of the flow path 3b from the viewpoint of cooling efficiency.

As illustrated in FIGS. 3 and 8, the heat sink 16 includes a pin-shaped protrusion 16a protruding in the stacking direction Dz. In the present embodiment, six protrusions 16a are provided to pass through the slits of the bus bars 11, 12, and 13. The protrusion 16a is coupled to the board 14 in a thermally conductive manner by soldering. That is, the heat sink 16 can dissipate not only heat from the bus bars 11, 12, and 13 but also heat from the board 14 heated by the bus bars 11, 12, and 13. As described above, while heat generated by the bus bars 11, 12, and 13 is dissipated from the heat sink 16 disposed in the vicinity of the bus bars, heat of the board 14 heated by the bus bars 11, 12, and 13 is also dissipated from the heat sink 16 coupled to the board.

As illustrated in FIGS. 3 and 8, a recess 15a is formed in a portion of the housing 15 facing the package 21. As a result, a space S, which is a first air layer, is formed between the package 21 and the housing 15. That is, the space S is interposed between the bus bar 11 and the package 21. Similarly, a space, which is a second air layer, is interposed between the bus bar 12 and the package 22, and a space, which is a third air layer, is interposed between the bus bar 13 and the package 23. As a result, the package 21 is not in direct contact with the housing 15 heated by the bus bar 11 and the air layer with low thermal conductivity is interposed therebetween, so that heating of the package 21 can be suppressed.

### [Assembly and Attachment Procedure of Electric Current Sensor Device]

A procedure of assembling and attaching the electric current sensor device 7 described above will be described with reference to FIG. 3. The bus bars 11, 12, and 13 and the heat sink 16 are stacked in the stacking direction Dz and integrally formed with the housing 15 in advance. The board 14 is then attached to the housing 15 from the stacking direction Dz. At this time, the board 14 is supported by the housing 15.

Meanwhile, in the board 14, a through-hole 14a is formed at a position facing the protrusion 16a of the heat sink 16. While the protrusion 16a of the heat sink 16 is passed through the through-hole 14a of the board 14 and the board 14 is supported by the housing 15, the protrusion 16a is coupled to the board 14 in a thermally conductive manner by soldering. Furthermore, the electric current sensor device 7 is attached to the case 3a of the inverter device 3, and the packages 21, 22, and 23 are connected to the U-phase, V-phase, and W-phase coils of the three-phase AC motor 2 via the bus bars 11, 12, and 13, respectively.

### [Example]

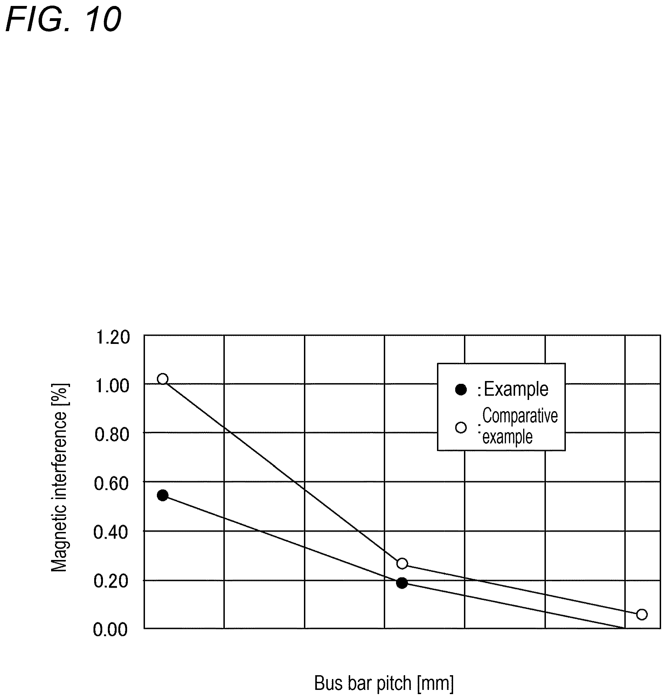

Measurement was performed using the electric current sensor device 7 described above. Here, a current was caused to flow through the bus bars 11 and 12, and the degree of magnetic interference from the bus bar 12 in the package 21 was measured with different pitches p1 between the bus bars 11 and 12. The results are illustrated in FIG. 10. As illustrated in FIG. 10, when the pitch p1 between the bus bars 11 and 12 was reduced, the degree of magnetic interference increased, but did not reach 1%, which is generally considered to be unfavorable.

### [Comparative Example]

In a case where Hall elements 100a and 100b were arranged in slits of bus bars, measurement similar to that in the example was performed as a comparative example. The arrangement positions of the Hall elements 100a and 100b are illustrated using the bus bar 13 in FIG. 5. Note that this is illustrated for the sake of explanation, and the Hall elements 100a and 100b are not provided in the embodiment. Here, a pitch d2 between the Hall elements 100a and 100b was set to 9 mm. The results are illustrated in FIG. 10. As illustrated in FIG. 10, when the pitch p1 between the bus bars 11 and 12 was reduced, the degree of magnetic interference increased, and reached 1%, which is generally considered to be unfavorable at the pitch p1 wider than that of the example. Therefore, it was confirmed that in the example, high accuracy was maintained even if the pitch p1 between the bus bars 11 and 12 was narrower than that in the comparative example. As a result, by reducing the space between the bus bars with the same accuracy, the electric current sensor device 7 can be downsized.

As described above, according to the electric current sensor device 7 of the present embodiment, the heat sink 16 is disposed on the side opposite to the board 14 with respect to the bus bars 11, 12, and 13 in the stacking direction Dz, and is coupled to the board 14 in a thermally conductive manner. Therefore, while heat generated by the bus bars 11, 12, and 13 is dissipated from the heat sink 16 disposed in the vicinity of the bus bars, heat of the board 14 heated by the bus bars 11, 12, and 13 is also dissipated from the heat sink 16 coupled to the board. As a result, heat generated by the bus bars 11, 12, and 13 can be efficiently dissipated while heat dissipation of the packages 21, 22, and 23 and the board 14 is ensured, and the influence of received heat can be reduced by reducing the heating of the packages 21, 22, and 23 and the board 14 from the bus bars 11, 12, and 13. In addition, since the heat dissipation of the bus bars 11, 12, and 13 and the board 14 can be performed by the single heat sink 16, an increase in the number of components can be suppressed as compared with a case where a separate heat dissipation member is provided for each of the bus bars 11, 12, and 13 and the board 14.

In addition, according to the electric current sensor device 7 of the present embodiment, since the heat sink 16 is made of metal made of a non-magnetic material, it is possible to maintain high detection accuracy without affecting the magnetic flux generated in the bus bars 11, 12, and 13.

Furthermore, according to the electric current sensor device 7 of the present embodiment, the protrusion 16a is coupled to the board 14 in a thermally conductive manner by soldering. As a result, the heat of the board 14 heated by the bus bars 11, 12, and 13 is conducted to the heat sink 16 via the protrusion 16a and dissipated.

In addition, according to the electric current sensor device 7 of the present embodiment, since the heat sink 16 is attached to the case 3a of the inverter device 3 for the three-phase AC motor 2 mounted on the vehicle 1, the efficiency of heat dissipation can be further enhanced.

Note that the case where the Hall element is applied as the magnetic detection element has been described in the present embodiment, but it is not limited thereto. That is, as long as the magnetic detection element can measure the magnetic flux generated by a current flow, for example, a magnetic impedance element, a magnetoresistive effect element, and the like can be widely applied as the magnetic detection element.

The case where the packages 21, 22, and 23 are mounted on one board 14 has been described in the present embodiment, but it is not limited thereto. For example, the packages 21, 22, and 23 may be mounted on separate boards.

### [Summary of Present Embodiment]

Preferably, the electric current sensor device (7) includes
a conductor (11, 12, 13),
a detector (21, 22, 23) detecting magnetism generated by a current flowing through the conductor (11, 12, 13),
a board (14) on which the detector (21, 22, 23) is mounted, and
a heat dissipation member (16) coupled to the conductor (11, 12, 13) in a thermally conductive manner, the heat dissipation member dissipating heat of the conductor (11, 12, 13),
and in the electric current sensor device,
the heat dissipation member (16) is disposed on a side opposite to the board (14) with respect to the conductor (11, 12, 13) in a stacking direction (Dz), and is coupled to the board (14) in a thermally conductive manner.

As a result, in the electric current sensor device (7), the heat dissipation member (16) is disposed on the side opposite to the board (14) with respect to the conductor (11, 12, 13) in the stacking direction (Dz), and is coupled to the board (14) in a thermally conductive manner. Therefore, while heat generated by the conductor (11, 12, 13) is dissipated from the heat dissipation member (16) disposed in the vicinity of the conductor, heat of the board (14) heated by the conductor (11, 12, 13) is also dissipated from the heat dissipation member (16) coupled to the board. As a result, heat generated by the conductor (11, 12, 13) can be efficiently dissipated while heat dissipation of the detector (21, 22, 23) and the board (14) is ensured, and the influence of received heat can be reduced by reducing the heating of the detector (21, 22, 23) and the board (14) from the conductor (11, 12, 13). In addition, since the heat dissipation of the conductor (11, 12, 13) and the board (14) can be performed by the single heat sink (16), an increase in the number of components can be suppressed as compared with a case where a separate heat dissipation member is provided for each of the conductor (11, 12, 13) and the board (14).

In the electric current sensor device (7),
the heat dissipation member (16) is preferably made of metal made of a non-magnetic material.

As a result, in the electric current sensor device (7), since the heat dissipation member (16) is made of metal made of a non-magnetic material, it is possible to maintain high detection accuracy without affecting the magnetic flux generated in the conductor (11, 12, 13).

Preferably, in the electric current sensor device (7),
the heat dissipation member (6) includes a protrusion (16a) protruding in the stacking direction (Dz), and
the board (14) is coupled to the protrusion (16a) in a thermally conductive manner by soldering.

As a result, in the electric current sensor device (7), the protrusion (16a) is coupled to the board (14) in a thermally conductive manner by soldering. Therefore, the heat of the board (14) heated by the conductor (11, 12, 13) is conducted to the heat dissipation member (16) via the protrusion (16a) and dissipated.

The electric current sensor device (7) further includes
a housing (15) provided to integrate the conductor (11, 12, 13) and the heat dissipation member (16),
and in the electric current sensor device,
the conductor (11, 12, 13) is coupled to the heat dissipation member (16) in a thermally conductive manner by being in contact with the heat dissipation member via the housing (15).

As a result, in the electric current sensor device (7), the conductor (11, 12, 13) and the heat sink (16) are not in direct contact with each other but are in contact with each other via the housing (15), so that the heat of the conductor (11, 12, 13) can be released from the heat dissipation member (16) without interposing other components therebetween.

Preferably, in the electric current sensor device (7),
the detector (21, 22, 23) includes a first magnetic detection element (21a, 22a, 23a) and a second magnetic detection element (21b, 22b, 23b) that detect magnetism generated by a current flowing through the conductor (11, 12, 13), and detects a current of the conductor (11, 12, 13) based on detection results of the first magnetic detection element (21a, 22a, 23a) and the second magnetic detection element (21b, 22b, 23b).

As a result, in the electric current sensor device (7), the current of the conductor (11, 12, 13) can be easily and accurately detected.

Preferably, in the electric current sensor device (7),
the conductor (11, 12, 13) is connected between an inverter circuit (5) that operates a rotary electric machine (2) operating with a three-phase alternating current and any one of three-phase coils of the rotary electric machine (2), and
the heat dissipation member (16) is attached to an aluminum die-cast case (3a) of an inverter device (3) that houses the inverter circuit (5).

As a result, in the electric current sensor device (7), since the heat dissipation member (16) is attached to the case (3a) of the inverter device (3) for the rotary electric machine (2) that is mounted on the vehicle (1) and operates with a three-phase alternating current, the efficiency of heat dissipation can be further enhanced.

The present disclosure is industrially applicable as an electric current sensor device that measures a current in an inverter device or the like for a three-phase AC motor mounted on an electric vehicle such as an automobile or a truck.

### REFERENCE SIGNS LIST

2: Three-phase AC motor (rotary electric machine), 3: Inverter device, 3a: Case 5: Inverter circuit, 7: Electric current sensor device, 11, 12, 13: Bus bar (conductor), 14: Board, 15: Housing, 16: Heat sink (heat dissipation member), 16a: Protrusion, 21, 22, 23: Package (detector), 21a: First Hall element (first magnetic detection element), 21b: Second Hall element (second magnetic detection element), 22a: Third Hall element (first magnetic detection element), 22b: Fourth Hall element (second magnetic detection element), 23a: Fifth Hall element (first magnetic detection element), 23b: Sixth Hall element (second magnetic detection element), and Dz: Stacking direction

## Claims

1. An electric current sensor device comprising:
a conductor;
a detector detecting magnetism generated by a current flowing through the conductor;
a board on which the detector is mounted; and
a heat dissipation member coupled to the conductor in a thermally conductive manner, the heat dissipation member dissipating heat of the conductor,
wherein
the heat dissipation member is disposed on a side opposite to the board with respect to the conductor in a stacking direction, and is coupled to the board in a thermally conductive manner.

2. The electric current sensor device according to claim 1, wherein the heat dissipation member is made of metal made of a non-magnetic material.

3. The electric current sensor device according to claim 1 or 2, wherein
the heat dissipation member includes a protrusion protruding in the stacking direction, and
the board is coupled to the protrusion in a thermally conductive manner by soldering.

4. The electric current sensor device according to any one of claims 1 to 3, further comprising a housing provided to integrate the conductor and the heat dissipation member,
wherein
the conductor is coupled to the heat dissipation member in a thermally conductive manner by being in contact with the heat dissipation member via the housing.

5. The electric current sensor device according to any one of claims 1 to 4, wherein
the detector includes a first magnetic detection element and a second magnetic detection element that detect magnetism generated by a current flowing through the conductor, and detects a current of the conductor based on detection results of the first magnetic detection element and the second magnetic detection element.

6. The electric current sensor device according to any one of claims 1 to 5, wherein
the conductor is connected between an inverter circuit that operates a rotary electric machine operating with a three-phase alternating current and any one of three-phase coils of the rotary electric machine, and
the heat dissipation member is attached to an aluminum die-cast case of an inverter device that houses the inverter circuit.
